# EUROPÄISCHE PATENTANMELDUNG

(11) **EP 2 845 920 A1**
(43) Veröffentlichungstag der Anmeldung: **11.03.2015**
(21) Anmeldenummer: 14186650.9
(22) Anmeldetag: 04.11.2008
(51) Int. Cl.: C23C 16/40, C23C 16/56, C23C 26/00, H01L 51/00, H01L 51/42, H01L 51/44

(54) **Oxidverbindungen als Beschichtungszusammensetzung**

(30) Priorität: 05.11.2007 DE 102007053023
(62) Teilanmeldung aus: 08846249.4
(71) Anmelder: Leibniz-Institut für Neue Materialien gemeinnützige GmbH, 66123 Saarbrücken (DE)
(72) Erfinder: Aktas, Oral Cenk, 66123 Saarbrücken (DE); Veith, Michael, 66386 St.-Ingbert (DE); Albayrak, Sener, 66123 Saarbrücken (DE); Siegert, Benny, 68100 Mulhouse (FR); Wolf, Yann Patrick, 66111 Saarbrücken (DE)
(74) Vertreter: Patentanwälte Gierlich & Pischitzis Partnerschaft

(57) **Zusammenfassung**

Die vorliegende Erfindung betrifft Element/Elementoxid-Kompositstrukturen als lichtabsorbierende Beschichtung insbesondere für Solarzellen, Sonnenkollektoren und Lichtschutzbeschichtungen.

## Beschreibung

### Gebiet der Erfindung

Die vorliegende Erfindung betrifft eine Beschichtungszusammensetzung bestehend aus Oxidverbindungen, ein Verfahren zur Herstellung dieser Oxidverbindungen sowie deren Verwendung.

### Stand der Technik

Oxidschichten ,insbesondere keramische und besonders Aluminiumoxid (Al₂O₃), werden als Beschichtungsmaterial für eine Vielzahl von Anwendung verwendet, die hohe Ansprüche an Hitze- und Hitzeschockstabilität oder Widerstand gegen Abnutzung, Oxidation oder Salzschmelzenkorrosion *(hot corrosion),* thermische Stabilität und elektrische Isolation stellen.

Solche Schichten können als eine Diffusionsbarriere für Ionen wirken und besitzen hohe chemische Stabilität und Strahlungsresistenz. Sie werden daher in vielen Bereichen eingesetzt. So dient beispielsweise Aluminiumoxid als Isolationsmaterial im Bereich der Mikroelektronik. Wegen seiner chemischen Resistenz und Biokompatibilität wird es auch im Bereich der Medizin verwendet. Beschichtungen mit Oxiden sind eine gute Möglichkeit, Oberflächen zum Beispiel gegen Oxidation oder Salzschmelzenkorrosion zu schützen. Diese hohe chemische Stabilität gepaart mit sehr vorteilhaften mechanischen Eigenschaften, machen Oxide zu einem idealen Material für Schutzschichten.

Dabei stellt die Herstellung geeigneter Oxidverbindungen eine große Herausforderung dar, insbesondere die Herstellung geeigneter Oxidverbindungen mit hoher Homogenität und Reinheit ist schwierig. So liegt bspw. Aluminiumoxid sowohl als amorphe Phase als auch in verschiedenen kristallinen Modifikationen mit unterschiedlichen Eigenschaften vor. Letztere weisen die für schützende Beschichtungen vorteilhafteren Eigenschaften auf, da amorphe Phasen normalerweise weicher sind. Kristallines Aluminiumoxid kann in verschiedenen Modifikationen vorliegen, von denen nur α-Al₂O₃ (Korund) thermodynamisch stabil ist. Die anderen, sogenannten Übergangs-Aluminiumoxide, wie γ, δ, η, θ, χ, χ'- Al₂O₃ und Al₂O₃-KII, sind metastabil und können irreversibel in α-Al₂O₃ überführt werden. Oberhalb von 1200 °C ist Korund die einzige stabile Modifikation. Dabei ist Korund auch die härteste Modifikation von Aluminiumoxid. Die geringe Ionenleitfähigkeit und seine hohe thermodynamische Stabilität machen es zu einer wichtigen Beschichtung gegen Oxidationen.

Im Stand der Technik sind eine Reihe von Verfahren bekannt, um Beschichtungen und Filme aus Aluminiumoxid herzustellen, wie zum Beispiel *chemical vapour deposition* (CVD), *physical vapour deposition* (PVD), hydrothermische Synthese (*hydrothermal synthesis),* Sputtern oder die Sol-Gel-Methode.

US 6,521,203 beschreibt die Herstellung von α-Al₂O₃ durch Kalzination von Aluminiumhydroxid, erzeugt durch Hydrolyse von Aluminiumisopropoxid, bei einer Temperatur von 700 bis 1300 °C. Diese Methode erlaubt jedoch keine Herstellung von dünnen Beschichtungen.

US 5,302,368 beschreibt die Herstellung von Beschichtungen durch Aufbringen einer Dispersion von Aluminiumhydroxid und/oder einem Übergangsaluminiumoxid in wässrigem Medium. Nach Einstellung der Suspension und Spühtrocknung wird das trockene Pulver in Gegenwart von einer chlorenthaltenden Substanz bei 1100 °C bis 1500 °C kalziniert.

Für industrielle Anwendungen zur Abscheidung von Oxidschichten wird üblicherweise *chemical vapour deposition* (CVD) bei hohen Temperaturen, normalerweise um die 1000 °C, verwendet, da diese Technik die Möglichkeit bietet auch komplexe Geometrien bei gut kontrollierbarer Stärke der Beschichtung zu beschichten.

US 5,654,035 beschreibt einen solchen Prozess, wobei der zu beschichtende Körper bei hoher Temperatur mit einem ein oder mehrere Aluminiumhalogenide enthaltenden Wasserstoffträgergas und einem hydrolisierenden oder oxidierenden Mittel in Berührung gebracht wird. Zusätzlich beschreibt US 6,713,172 die Anwendung dieses Verfahrens zum Beschichtung von Schneidwerkzeugen, erneut bei hohen Temperaturen von etwa 1000 °C.

US 7,238,420 beschreibt einen Nanotemplat aus relativ reinem und vollständig kristallinem α-Al₂O₃ auf einer Metalllegierung. Im offenbarten Herstellungsverfahren wird kristallines α-Al₂O₃ mit Hilfe von CVD direkt auf der Oberfläche der Legierung erzeugt. Dazu wird diese vor der Abscheidung mit einer CO₂/H₂-Mischung bei hohen Temperaturen von 1000 °C bis 1200 °C vorbehandelt.

Alle beschriebenen Verfahren benötigen hohe Temperaturen. Diese limitieren nicht nur die möglichen Substrate, sondern können auch zu thermischen Sprüngen in der Beschichtung führen. So haben die Oxidbeschichtungen und das Substrat häufig verschiedene thermischen Ausdehnungskoeffizienten von Film und Substrat, was zu thermisch induzierten Sprüngen in der Beschichtung führt.

Um die hohen Temperaturen zu umgehen, wurden große Anstrengungen unternommen Verfahren zu entwickeln, die es ermöglichen Oxidschichten bei niedrigeren Temperaturen abzuscheiden, zum Beispiel durch *physical vapour deposition* (PVD).

US 5,683,761 beschreibt ein Verfahren zur Ablagerung von α-Al₂O₃ mit Hilfe von Elektronenstrahl-PVD. Allerdings muss das Substrat auf ungefähr 1000 °C aufgeheizt werden. Auch die Ablagerung von reinem Oxid, in diesem Fall α-Al₂O₃, benötigt also hohe Temperaturen.

Varianten der CVD-Verfahren, wie *plasma assisted*/*enhanced chemical vapour deposition* (PACVD/PECVD) oder *metal organic chamical vapour deposition* (MOCVD) bieten ebenso die Möglichkeit niedrigere Temperaturen zu verwenden.

So beschreibt Pradhan et al. (Surf. Coat. Tech. 176 (2004) 382-384), dass der Einsatz von metallorganischen Aluminiumverbindungen zur Bildung von kristallinem Aluminiumoxid bei niedrigen Temperaturen (höher als 550 °C) führt. Bei niedrigeren Temperaturen wurden nur amorphe Filme erhalten.

MOCVD-Verfahren bieten zwar viele Vorteile, wie zum Beispiel niedrigere Temperaturen, einfache Prozesse, gleichmäßige Beschichtungen oder die Verwendung eines einzigen Vorläufers, aber sie führen auch zu kohleartigen Verunreinigungen in der Beschichtung.

Der Grad der Kristallinität und die kristallinen Phasen innerhalb der abgelagerten Oxidschicht sind sehr wichtig für ihre mechanischen Eigenschaften. Eine reine Phase mit hoher thermischer und mechanischer Stabilität ist gegenüber einer Mischung unterschiedlicher Phasen deutlich bevorzugt. Allerdings ist dazu eine geeignete Hitzebehandlung des beschichteten Substrats nötig, die nicht nur zur Transformation in die gewünschte Phase führt, sondern noch zusätzlich zu einer Verdichtung der Beschichtung, was ebenfalls für die mechanische Stabilität der Schicht eine große Rolle spielt. Eine solche Hitzebehandlung erfordert häufig Temperaturen von über 1200 °C, die für viele Substrate nicht geeignet sind.

Um das Erhitzen des gesamten beschichteten Substrats zu vermeiden, bietet sich eine lokale Hitzebehandlung an. In diesem Zusammenhang wurden bereits Laser zur Behandlung von solchen keramischen Materialien mit Erfolg eingesetzt (Lasersintern). Dabei wird die Beschichtung in einem kleinen Bereich mit Hilfe eines Laserstrahls erhitzt. Gerade im Gebiet der Oxidkeramiken werden diese Verfahren eingesetzt, da sie im Bereich der verwendeten CO₂-Laser absorbieren. Ein besonderes Problem stellt dabei die Bildung von thermisch bedingten Sprüngen bei der Wiederverfestigung und Abkühlung des Materials dar. Sie resultieren aus der Sprödigkeit der Keramiken und aus dem hohen Temperaturgefälle zwischen Einwirkungsbereich und umgebenden Material, sowie den unterschiedlichen thermischen Ausdehnungskoeffizienten von Beschichtung und Substrat.

So beschreiben Triantafyllids et al. (Appl. Surf, Sci.186 (2002) 140-144) und WO 2007/102143 das Auftreten von thermisch induzierten Rissen beim Lasersintern. Solche Fehlstellen beeinflussen natürlich die Dichte und Stabilität der Beschichtung und die Homogenität der Phasentransformation.

Diese Effekte lassen sich durch Zugabe von Bindemitteln zu den Oxidverbindungen, bspw. den Aluminiumoxidpartikeln, vermindern. So beschreibt US 6,048,954 eine solche Bindemittelzusammensetzung für hochschmelzende anorganische Partikel. Solche Bindemittel erhöhen zwar die Verdichtung der Beschichtung, sind aber nur für pulverförmige Materialen anwendbar und das Bindemittel sowie seine Rückstände müssen nach dem Lasersintern entfernt werden oder verbleiben sogar in der Oxidschicht.

Da die Effizienz des Lasersinterns im hohen Maße von der Absorption des zu sinternden Materials abhängt, ist die Absorption ein wichtiges Kriterium. Dabei kann auch das Bindemittel zur Absorption beitragen. So beschreibt US 6,007,764 die Verwendung einer Mischung von absorbierenden und keramischen Partikeln umd die Absorption zu verbessern. Zheng et al. (Mat. Lett. 60 (2006) 1219-1223) verwenden mit Polystyrol beschichtete Aluminiumoxidpartikel, um die Absorption für CO₂-Laser zu optimieren. Diese Partikel zeigten eine besser Absorption und damit auch gleichmäßigeres Aufheizen und einen reduzierten Temperaturgradienten. Allerdings bleibt immer organisches Material als Rückstand in der Beschichtung.

DE 10 2006 013 484 A1 beschreibt die Herstellung eines Element/Elementoxid-Kompositmaterials, das heißt einem Material, das Element und das entsprechende Elementoxid enthält, in diesem Falle von Nanodrähten mit Metallkern und Oxidhülle.

Der Nachteil der meisten Verfahren zur Herstellung von Oxidschichten liegt in den hohen Temperaturen des Verfahrens. Bei den Lasersinter-Verfahren liegen die wesentlichen Nachteile darin, dass nur sehr spezielle Laser in einem bestimmten Wellenlängenbereich, meistens CO₂-Laser, geeignet sind zum Einsatz zu kommen, die verwendeten Vorläufer andere Wellenlängen nicht absorbieren. Dies bedingt hohe Temperaturgradienten und führt zu einer höheren Belastung des Substrats und zu thermisch induzierten Rissen und Fehlstellen. Daher ist häufig die Zugabe von zusätzlichen Bindemitteln nötig, um die Absorption der Laserenergie zu erhöhen und eine hohe Qualität der Beschichtung zu erreichen. Allerdings bleiben Rückstände dieser Bindemittel in der Beschichtung zurück. Auch erfordert die Herstellung von hochwertigen und fehlerfreien Beschichtungen ein hohes Maß an Erfahrung, da eine Beeinflussung des darunterliegenden Substrats oder eine zu starke Erhitzung vermieden werden muss.

### Aufgabe

Der vorliegenden Erfindung liegt die Aufgabe zugrunde, die Nachteile des Standes der Technik bei der Herstellung von Oxidschichten als Beschichtungszusammensetzung zu überwinden. Aufgabe der Erfindung ist es insbesondere ein Verfahren anzugeben, dass die Herstellung geeigneter Oxidverbindungen als Beschichtungszusammensetzung ermöglicht.

### Lösung

Diese Aufgabe wird durch die Erfindung mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindung umfasst auch alle sinnvollen und insbesondere alle erwähnten Kombinationen von unabhängigen und/oder abhängigen Ansprüchen.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Zur Lösung der genannten Aufgabe wird ein Verfahren zur Herstellung von Oxidschichten vorgeschlagen, welches folgende Verfahrensschritte umfasst:
a) Aufbringen einer Element/Elementoxid-Kompositstruktur auf dem Substrat
b) (Kurzes) lokales Erhitzen der Element/Elementoxid-Kompositstruktur, vorzugsweise mittels eines Lasers.

Durch das erfindungsgemäße Verfahren werden überraschenderweise Oxidschichten erhalten, die wenige bis keine Defekte und eine hohe Härte und Verdichtung aufweisen. Die Kompositstruktur wird als Kompositstruktur bezeichnet, da sie sowohl aus dem Element, als auch aus dem Elementoxid besteht.

Die erfindungsgemäße Beschichtung der Oberfläche mit den Element/Elementoxid-Kompositstruktur wird vorzugsweise nach dem *metal organic chamical vapour deposition* (MOCVD) Verfahren durchgeführt. In diesem Verfahren werden metallorganischen Vorläufer (Precursoren) in die Gasphase überführt und thermolytisch zersetzt, wobei das nichtflüchtige Zersetzungsprodukt sich in der Regel an oder auf dem Substrat anlagert. Die in der Erfindung eingesetzten Vorläufer besitzen die allgemeine Formel

El(OR)ₙH₂

wobei El Al, Ga, In, Tl, Si, Ge, Sn, Pb oder Zr bedeutet und R für einen aliphatischen oder alicyclischen Kohlenwasserstoffrest steht und n den Wert 1 oder 2 hat.

Der aliphatische und alicyclische Kohlenwasserstoffrest ist bevorzugt gesättigt und besitzt beispielsweise eine Länge von 1 bis 20 C-Atomen. Bevorzugt sind Alkyl oder unsubstituiertes oder Alkyl-substituiertes Cycloalkyl. Der Alkylrest besitzt vorzugsweise 2 bis 15 C-Atome, bevorzugt 3 bis 10 C-Atome und kann linear oder verzweigt sein, wobei verzweigte Alkylreste bevorzugt sind. Als Beispiele seien hier aufgeführt: Ethyl, n-Propyl, n-Butyl und die entsprechenden höheren linearen Homologe, Isopropyl, sek.-Butyl, Neopentyl, Neohexyl und die entsprechenden höheren Isoalkyl- und Neoalkylhomologe oder 2-Ethylhexyl. Die alicyclischen Ringe können einen, zwei oder mehr Ringe umfassen, die jeweils mit Alkyl substituiert sein können. Der alicyclische Rest besitzt vorzugsweise 5 bis 10, besonders bevorzugt 5 bis 8 C-Atome. Als Beispiele seien aufgeführt: Cyclopentyl, Cyclohexyl, Methylcyclohexyl, Norbonyl und Adamantyl.

Vorzugsweise kommen erfindungsgemäß Oxidverbindungen zum Einsatz, die keramische Oxide bilden.

Besonders bevorzugt sind Aluminiumalkoxydihydride, die verzweigte Alkoxyreste mit 4 bis 8 C-Atomen aufweisen, insbesondere Aluminium-tert.-butoxydihydrid. Die Herstellung solcher Verbindungen wird in DE 19529241 A1 beschrieben. Sie können beispielsweise durch Umsetzung von Aluminiumhydrid mit dem entsprechenden Alkohol im Molverhältnis 1:1 erhalten werden, wobei das Aluminiumhydrid *in situ* durch Reaktion eines Alkali-Aluminiumhydrids mit einem Aluminiumhalogenid hergestellt werden kann. Desweiteren wird die Herstellung solcher Verbindungen auch von Veith et al. (Chem. Ber. 1996, 129, 381-384) beschrieben, wobei auch gezeigt wird, dass die Verbindungen der Formel El(OR)H₂ auch dimere Formen umfassen können.

Die Verbindungen werden vorzugsweise in die Gasphase überführt und thermolytisch zersetzt, wobei das nicht flüchtige Zersetzungsprodukt in der Regel an oder auf einem Substrat in Form der Element/Elementoxid-Kompositstruktur gebildet wird. Als Substrate zum Aufbringen der Beschichtung kommen alle üblichen Materialien in Betracht, beispielsweise Metall, Keramik, Legierungen, Quarz, Glas oder Glas-ähnliche, vorzugsweise inert gegenüber den Ausgangs- und Endprodukten. Die Thermolyse kann z.B. in einem Ofen, an einer induktiv beheizten Oberfläche oder an einer auf einem induktiv geheizten Probenträger befindlichen Oberfläche durchgeführt werden. Bei induktiver Heizung können lediglich leitfähige Substrate, wie beispielsweise Metalle, Legierung oder Graphit verwendet werden. Bei Substraten mit geringer Leitfähigkeit sollte bei induktiver Heizung ein elektrisch leitendender Substratträger oder Ofen verwendet werden. Das Substrat kann daher sowohl eine Oberfläche des Reaktionsraums, als auch ein darin platziertes Substrat sein. Der eingesetzte Reaktorraum kann jede beliebige Gestalt aufweisen und aus jedem üblichem inertem Material bestehen, beispielsweise Duran- oder Quarzglas. Es können Reaktorräume mit heißen oder kalten Wänden verwendet werden. Die Heizung kann elektrisch oder mit anderen Mitteln erfolgen, vorzugsweise mit Hilfe eines Hochfrequenzgenerators. Der Ofen, sowie der Substratträger können beliebige Formen und Größen entsprechend der Art und Form des zu beschichtenden Substrats aufweisen, so kann das Substrat beispielsweise eine Platte, plane Oberfläche, röhrenförmig, zylindrisch, quaderförmig sein oder ein komplexere Form aufweisen.

Es kann vorteilhaft sein, den Reaktorraum vor dem Einleiten des Precursors mehrmals mit einem inertem Gas, vorzugsweise Stickstoff oder Argon, zu spülen. Außerdem kann es von Vorteil sein, gegebenenfalls ein zwischenzeitliches Vakuum anzulegen, um den Reaktorraum zu inertisieren.

Desweiteren kann es vorteilhaft sein, vor dem Einleiten des metallorganischen Vorläufers das zu beschichtende Substrat, beispielsweise Metall, Legierung, Halbleiter, Keramik, Quarz, Glas oder Glasähnlich, auf über 500 °C zu erhitzen, um die Oberfläche zu reinigen.

Die gewünschte Element/Elementoxid-Kompositstruktur entsteht bevorzugt bei Temperaturen von über 400 °C, besonders bevorzugt über 450 °C. Bevorzugt sind Temperaturen von nicht über 1200 °C, insbesondere nicht mehr als 600 °C, z.B. 400 °C bis 1200 °C und vorzugsweise 450 °C bis 650 °C insbesondere bevorzugt 450 °C bis 600 °C. Das Substrat auf bzw. an dem die Thermolyse stattfindet wird dementsprechend auf die gewünschte Temperatur erhitzt. Die Erzeugung der erfindungsgemäßen Element/Elementoxid-Kompositstruktur ist dabei unabhängig vom verwendeten Substratmaterial und dessen Beschaffenheit.

Die (metallorganische) Verbindung, bzw. der Precursor kann aus einem Vorratsgefäß, das bevorzugt auf eine gewünschte Verdampfungstemperatur temperiert ist, in den Reaktor eingeleitet werden. So kann es zum Beispiel auf eine Temperatur zwischen -50°C und 120 °C, bevorzugt zwischen -10°C und 40°c temperiert sein. Die Thermolyse im Reaktorraum erfolgt in der Regel bei einem Unterdruck von 10⁻⁶ mbar bis Atmosphärendruck, vorzugsweise in einem Bereich von 10⁻⁴ mbar bis 10⁻¹ mbar, bevorzugt 10⁻⁴ mbar bis 10⁻² mbar. Zur Erzeugung des Vakuums kann ausgangsseitig ein Vakuumpumpensystem an den Reaktor angeschlossen werden. Es können alle üblichen Vakuumpumpen verwendet werden, bevorzugt ist eine Kombination aus Drehschieberpumpe und Turbomolekularpumpe oder eine Drehschieberpumpe. Zweckmäßigerweise ist auf der Seite des Reaktorraums das Vorratsgefäß für den Precursor angebracht und auf der anderen Seite das Vakuumpumpensystem.

Bei Erhitzung des Substrats durch Induktion können z.B. quadratzentimetergroße, elektrisch leitende Metallplättchen oder - folien als Substrat in einem Reaktionsrohr aus Duran- oder Quarzglas angeordnet werden. Bei Anpassung der Dimensionen der Apparatur sind ebenso Substratflächen im Bereich von Quadratdezimetern bis hin zu mehreren Quadratmetern möglich. An dem Reaktionsrohr sind eingangsseitig das auf die gewünschte Verdampfungstemperatur temperierte Vorratsgefäß mit dem Precursor und ausgangsseitig ein Vakuumpumpensystem angeschlossen. Das Reaktionsrohr befindet sich in einem Hochfrequenzinduktionsfeld, mit dessen Hilfe die Substratplättchen oder -folien auf die gewünschte Temperatur erhitzt werden. Nach Einstellen des gewünschten Drucks und Einleiten des Precursors wird das Substrat mit der Element/Elementoxid-Kompositstruktur bedeckt.

Es ist vorteilhaft, die Flussrate des Precursors mit einem Ventil zu regulieren. Das Ventil kann manuell oder automatisch gesteuert werden. Abhängig von der gewünschten Dicke der Beschichtung kann die Dauer der Zugabe des Precursors wenige Minuten bis zu mehreren Stunden betragen.

Durch Variation eines oder mehrerer Prozessparameter ausgewählt aus Substrattemperatur, Gasdruck, Precursorvorlagentemperatur, Precursorfluss (Menge an eingeleitetem Precursor pro Zeiteinheit) und Bedampfungszeit kann die Morphologie der Element/Elementoxid-Kompositstruktur gesteuert werden.

In einer weiteren Weiterbildung kann die erhaltene Element/Elementoxid-Kompositstruktur einer Behandlung mit einem Gemisch, einer Lösung und/oder einer Suspension von organischen und/oder anorganischen Substanzen unterzogen werden.

In einer weiteren Ausprägung der Erfindung kann das Substrat nur in gewünschten Bereichen mit der Element/Elementoxid-Kompositstruktur überzogen werden, was auch die Behandlung durch lokales Erhitzen auf diese Bereiche beschränkt.

Nach Abkühlen wird die Element/Elementoxid-Kompositstruktur lokal erhitzt, besonders bevorzugt mit Hilfe eines Lasers. Dieser Vorgang wird auch als Sintern bezeichnet. Dabei wird die Element/Elementoxid-Kompositstruktur in die gewünschte Elementoxidstruktur umgewandelt. Diese Veränderung kann auch die Umwandlung in eine oder mehrere Modifikationen einer Kristallstruktur beinhalten, besonders bevorzugt ist dabei die Bildung einer einzigen Modifikation des Elementoxids.

Als besonderer Vorteil der Erfindung besitzt die Element/Elementoxid-Kompositstruktur eine bessere thermische Leitfähigkeit als das reine Elementoxid und führt dadurch zu einem reduzierten Temperaturgradienten während des lokalen Erhitzens. Dies reduziert die dadurch induzierten Risse.

In einer vorteilhaften Weiterbildung der Erfindung kann die elementare Komponente der Element/Elementoxid-Kompositstruktur als Bindemittel fungieren, indem sie während des Erhitzens schmilzt und so eventuell durch das Erhitzen in der Element/Elementoxid-Kompositstruktur entstandenen Risse und Poren ausfüllen kann. Dadurch ist keine Zugabe eines separaten Bindemittels nötig, was zu ungewünschten Rückständen führen könnte.

In einer vorteilhaften Weiterbildung der Erfindung wird die Element/Elementoxid-Kompositstruktur am Ort der Erhitzung nicht vollständig in das entsprechende Elementoxid umgewandelt. Durch Steuerung der Laserintensität und der Einwirkdauer kann der Grad der Umwandlung sehr genau gesteuert werden. Dies ermöglicht die selektive Herstellung von Bereichen bestimmter Struktur und Morphologie, und damit beispielsweise die Herstellung von Nanodrähten, Nanopartikeln und fraktalen Oberflächen.

In einer weiteren vorteilhaften Weiterbildung der Erfindung wird die Element/Elementoxid-Kompositstruktur am Ort der Erhitzung vollständig in das entsprechende Elementoxid umgewandelt. Durch Steuerung der Laserintensität und der Einwirkdauer kann der Grad der Umwandlung bis hin zur vollständigen Umwandlung gesteuert werden. Durch das Schmelzen der metallischen Komponente der Element/Elementoxid-Kompositstruktur ist die Herstellung besonders defektfreier und gleichmäßiger Oxidschichten möglich.

Ein weiterer großer Vorteil der vorliegenden Erfindung ist die Möglichkeit, die Wellenlänge des Lasers aus einem großen Wellenlängenbereich wählen zu können. Die hergestellte Element/Elementoxid-Kompositstruktur kann ein Breitbandabsorber sein und folglich Licht aus einem sehr breiten Wellenlängenbereich absorbieren. Die Wellenlänge des Lasers kann im Bereich von UV bis zu elektromagnetischen Wellen liegen, vorzugsweise im Bereich von 300 nm bis 15 µm, besonders bevorzugt im Bereich von 500 nm bis 11 µm, noch vorteilhafter, aber nicht beschränkt auf Laser mit den Wellenlängen 488 nm, 514 nm, 532 nm, 635 nm, 1064 nm oder 10.6 µm. Es können kontinuierliche (CW) oder gepulste Laser verwendet werden.

Vorzugsweise liegt die verwendete Laserenergie abhängig von der verwendeten Wellenlänge und der Element/Elementoxid-Kompositstruktur zwischen 1 Milliwatt pro Quadratzentimeter und mehreren Watt pro Quadratzentimeter, bevorzugt zwischen 1 Milliwatt pro Quadratzentimeter und 10 Watt pro Quadratzentimeter, besonders bevorzugt zwischen 1 mW/cm² und 5 W/cm².

Ein besonderer Vorteil der Erfindung ist die Realisierung von sehr geringen Eindringtiefen des Lasers. So kann die Eindringtiefe beispielsweise bei Verwendung eines gepulsten Lasers auf einen Bereich von kleiner ca. 400 nm reduziert werden, bevorzugt kleiner ca. 300 nm, besonders bevorzugt kleiner ca. 200 nm, insbesondere bevorzugt kleiner ca. 100 nm reduziert werden. Dies ermöglicht nicht nur die Herstellung sehr dünner Schichten, sondern auch eine besondere Schonung des Substrats. Die Schichtdicke der hergestellten Elementoxidschicht kann dementsprechend zwischen ca. 400 nm und ca. 10 nm, bevorzugt zwischen ca. 300 nm und ca. 10 nm, besonders bevorzugt zwischen ca. 200 nm und ca. 10 nm, insbesondere bevorzugt zwischen ca. 100 nm und ca. 10 nm liegen. Theoretisch wäre sogar die Erzeugung nur weniger Monolagen Elementoxid möglich, d.h. nur wenige Lagen von Atomen. Desweiteren schützt die geringe Eindringtiefe ein temperaturempfindliches Substrat vor thermischem Energieeintrag und zusätzlich werden mechanische Spannungen an der Grenzfläche zwischen Beschichtung und Substrat vermieden. So können auch Substrate verwendet werden, die selbst die verwendete Laserwellenlänge absorbieren. Außerdem kann auch nur die Oberfläche einer Element/Elementoxid-Kompositstruktur mit größerer Schichtdicke umgewandelt werden.

Ein weiterer Besonderer Vorteil der Erfindung liegt in der Möglichkeit nicht nur besonders dünne, sondern auch besonders harte Oxidschichten herstellen zu können, welche besonders bevorzugt durch geringe Permeabilität einen hohen Korrosionsschutz bieten.

In einer weiteren vorteilhaften Weiterbildung der Erfindung wird die Lichtabsorption der Element/Elementoxid-Kompositstruktur an der Stelle der Behandlung, während der Erhitzung oder zwischen mehreren Sintervorgängen, gemessen. Durch die Umwandlung der Element/Elementoxid-Kompositstruktur in das gewünschte Elementoxid kann sich die Absorption, beispielsweise von Licht im sichtbaren Bereich, am Ort der Erhitzung verändern. Aus dieser Veränderung ist es möglich einen bestimmten Grad der Umwandlung durch Anpassung von Verfahrensparametern, wie beispielsweise aber nicht beschränkt auf Laserintensität, Wellenlänge, Einwirkzeit des Lasers, Wiederholungen der Erhitzung, zu erzeugen. Nach Erreichen des gewünschten Grads kann die Erhitzung an diesem Ort beendet werden.

In einer besonders vorteilhaften Ausprägung der Erfindung wird die Wellenlänge des Lasers derart gewählt, dass sie von einer reinen Elementoxidschicht reflektiert wird. Dadurch kommt es nach erfolgter vollständiger Umwandlung der Element/Elementoxid-Kompositstruktur am Ort der Erhitzung zu keiner weiteren Absorption des Laserlichts, da das nun vorliegende Elementoxid dieses nicht absorbiert. Dadurch kann die Umwandlung beim Erreichen des reinen Elementoxids "von selbst" gestoppt werden, da es zu keiner weiteren Erwärmung durch den Laser kommt. Dadurch wird eine "Überhitzung" der Elementoxidschicht vermieden, die zu Fehlstellung, zum Beispiel durch Bildung von Körnung, in der Elementoxidschicht führen kann. Außerdem kann auf diese Weise das unter der Schicht liegende Substrat geschont werden. Gleichzeitig erlaubt diese Weiterbildung die Verwendung höherer Laserintensitäten als in herkömmlichen Verfahren bei gleicher Schichtdicke und Substrat möglich waren.

Besonders bevorzugt werden für diese Ausprägung der vorliegenden Erfindung Laser mit Wellenlängen im sichtbaren Bereich des Lichts gewählt. Durch die Absorptionseigenschaften der erfindungsgemäßen Element/Elementoxid-Kompositstruktur ist die lokale Erhitzung mit Lasern mit diesem Wellenlängenbereich möglich.

Alternativ kann das "Überhitzen" der erzeugten Oxidschicht auch dazu verwendet werden, eine bestimmte Porosität durch das gezielte Erzeugen von Fehlstellen einzustellen.

Ein weiterer Vorteil der vorliegenden Erfindung liegt in der Möglichkeit die Erhitzung lokal, d.h. nicht nur unter Schonung des darunterliegenden Substrats, sondern auch nur in gewünschten Bereichen der Element/Elementoxid-Kompositstruktur durchzuführen, wenn beispielsweise nur auf der Außenseite des Substrats eine solche Beschichtung gewünscht wird. Andererseits ist es ebenso möglich die gesamte Oberfläche des Substrats zu behandeln, besonders bevorzugt durch linienweises Abtasten mit Hilfe eines computergesteuerten Laserscanners.

Ein weiterer Vorteil der vorliegenden Erfindung liegt in der Möglichkeit durch gezielte anteilige oder vollständige Umwandlung der Element/Elementoxid-Kompositstruktur eine bestimmte gewünschte Struktur auf der Oberfläche des Substrats zu erzeugen. Durch die Möglichkeit Laser kürzerer Wellenlängen zu verwenden, sind Strukturen mit deutlich höherer Auflösung als mit den bisher üblichen CO₂-Lasern möglich, theoretisch begrenzt durch die Hälfte der verwendeten Wellenlänge.

Desweiteren kann die erfindungsgemäße lokale Erhitzung mit Hilfe eines computergesteuerten Laserscanners durchgeführt werden, vorzugsweise mit einer fokussierenden Optik, um den Laserstrahl besser zu fokussieren.

Die vorliegende Erfindung betrifft ferner eine Beschichtungszusammensetzung, insbesondere herstellbar durch das oben genannte erfindungsgemäße Verfahren, umfassend Oxidschichten mit hohem bis vollständigen Oxidanteil, die durch thermolytische Zersetzung von metallorganischen Verbindungen der Formel El(OR)ₙH₂ worin El Al, Ga, In, Tl, Si, Ge, Sn, Pb oder Zr bedeutet und R für einen aliphatischen oder alicyclischen Kohlenwasserstoffrest steht und n den Wert 1 oder 2 hat, bei einer Temperatur von mehr als 400 °C unter Bildung einer Element/Elementoxid-Kompositstruktur hergestellt sind und die hergestellte Element/Elementoxid-Kompositstruktur durch kurzes, lokales Erhitzen, vorzugsweise mittels eines Lasers (sintern) in die Oxidverbindung überführt wird.

Vorzugsweise beträgt der Anteil der Oxidverbindung in der Beschichtungszusammensetzung mindestens 80%, vorzugsweise mindestens 95%, besonders bevorzugt nahezu 100%

Vorzugsweise ist die Oxidverbindung ein keramisches Oxid, besonders bevorzugt ist Aluminium- oder Galliumoxid, insbesondere bevorzugt Aluminiumoxid und am bevorzugtesten Aluminiumoxid als α-Al₂O₃ (Korund).

Erfindungsgemäß kann die Beschichtungszusammensetzung eine große Härte besitzen, beispielsweise kann im Falle von Aluminiumoxid eine Härte von ungefähr 28 GPa erreicht werden.

Desweiteren zeichnen sich die erfindungsgemäßen Beschichtungszusammensetzungen durch eine hohe Adhäsion an das Substrat aus. Als weiteren Vorteil besitzen die erfindungsgemäßen Beschichtungszusammensetzungen einen geringen Diffusionskoeffizienten für Ionen, sowie eine geringe Permeabilität für Wasser. Durch diese Eigenschaften eignen sie sich insbesondere als Schutz des Substrats vor Korrosion oder Abnutzung und Abrieb.

Desweiteren betrifft die Erfindung die Verwendung der erfindungsgemäßen Beschichtungszusammensetzung zur Beschichtung von Substraten aus bspw. Metall, Halbleiter, Legierung, Keramik, Quarz, Glas oder Glasähnlichen Materialien. Dies stellt lediglich eine Auswahl der möglichen Substrate und keinesfalls eine Einschränkung dar. Generell kann die erfindungsgemäße Beschichtungszusammensetzung auf (fast) alle Substrate aufgebracht werden. Geeignete Substrate sind dem Fachmann bekannt.

Die Vielseitigkeit des erfindungsgemäßen Verfahrens bezüglich der Umwandlung der Element/Elementoxid-Kompositstruktur erlauben zahlreiche Anwendungen. Erfindungsgemäß können sehr harte, abnutzungsresistente Schutzschichten für Bauteile mit hohem Verschleiß und Abnutzung hergestellt werden. Die Möglichkeit sehr defektfreie Schichten herzustellen ermöglicht die Verwendung der Schutzschichten zur elektrischen oder thermischen Isolation. Weiterhin sind auch Anwendungen im Bereich der Medizin, insbesondere als Beschichtung für Implantate möglich. Gezielt strukturierte Oberflächen gemäß der Erfindung eignen sich beispielsweise im Bereich der Katalyse, Filtration oder Lithographie bis hin zu Speichermedien, wie Informationsspeicherung.

Desweiteren eignet sich die erfindungsgemäße Element/Element-Kompositstruktur wegen ihrer Absorptionseigenschaften zur Herstellung von Oberflächen mit Absorption eines breiten Wellenlängenbereichs. Beispielsweise für Lichtenergieabsorbierende Beschichtungen für Solarzellen, Lichtschutzbeschichtungen, Sonnenkollektoren und dgl..

Desweiteren umfasst die Erfindung eine Vorrichtung zur Durchführung der lokalen Erhitzung vorzugsweise mit Hilfe eines Lasers, bevorzugt mit einem computergesteuerten Laserscanner, besonders bevorzugt mit einer den Laserstrahl fokussierenden Optik.

Eine weitere vorteilhafte Weiterbildung der erfindungsgemäßen Vorrichtung umfasst die Möglichkeit die Lichtabsorption der Element/Elementoxid-Kompositstruktur an der Stelle der Behandlung, während der Erhitzung oder zwischen mehreren Sintervorgängen, zu messen. Dies kann durch die Messung der Intensität der Reflektion des Lasers am Ort der Erhitzung oder durch Messung der Intensität der Reflektion am Ort der Erhitzung mit einer anderen Lichtquelle mit geeigneter Wellenlänge während des Sinterns oder zwischen mehreren Sintervorgängen geschehen. Dies erlaubt eine vollständige Automatisierung des erfindungsgemäßen Verfahrens.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

XRD-Analyse: Röntgenbeugungsanalyse
- Fig. 1: Aufnahme einer unbehandelten Al/Al₂O₃-Kompositstruktur
- Fig. 2: Aufnahme einer behandelten Al/Al₂O₃-Kompositstruktur (5 Watt Laser 5 mm/sec);
- Fig. 3: Aufnahme einer behandelten Al/Al₂O₃-Kompositstruktur (10 Watt Laser; 2 mm/sec);
- Fig. 4: Absorptionsspektrum einer Al/Al₂O₃-Kompositstruktur (Dicke: 200-400 nm)
- Fig. 5: Röntgenbeugungsanalyse (XRD) von verschiedenen Al/Al₂O₃-Kompositstrukturen auf rostfreiem Stahl
- Fig. 6: Röntgenbeugungsanalyse (XRD) von verschiedenen Al/Al₂O₃-Kompositstrukturen auf Titan
- Fig. 7: Aufnahme einer partiell und mit zunehmender Energie behandelte Al/Al₂O₃-Kompositstrukturen
- Fig. 8:: Untersuchung der Wasserpermeabilität von verschiedenen Al/Al₂O₃-Kompositstrukturen
- Fig. 9:: Messung der Härte einer erfindungsgemäß hergestellten α-Al₂O₃-Schicht.

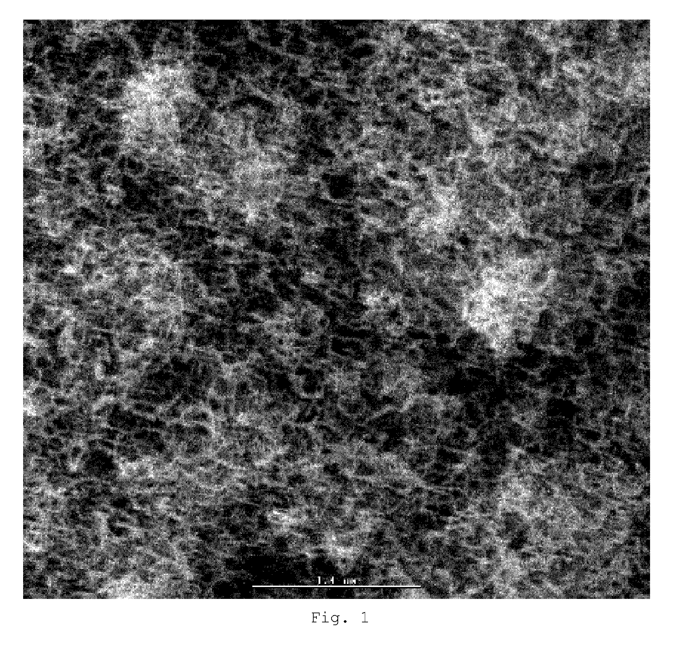

Die Abbildungsserie Fig. 1 bis 3 zeigt deutlich den Einfluss der Einwirkung des Lasers in Abhängigkeit der Einwirkdauer, in diesem Fall gegeben durch die Geschwindigkeit, mit der der Laser über die Probe hinwegbewegt wurde.

Im Detail zeigt Fig 1 eine unbehandelte Al/Al₂O₃-Kompositstruktur vor der Laserbehandlung. Es ist weder eine einheitliche Oberfläche noch eine Strukturierung der Oberfläche zu erkennen.

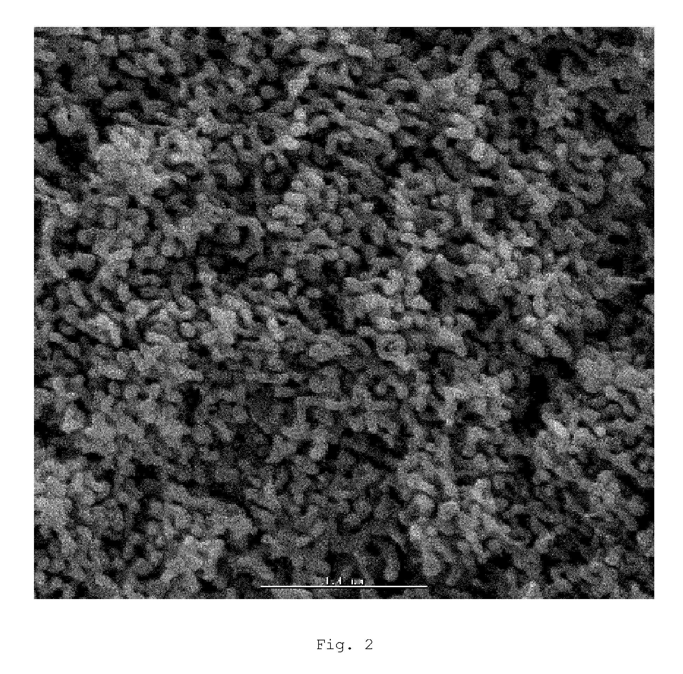

Fig 2 zeigt eine Al/Al₂O₃-Kompositstruktur nach kurzer Laserbehandlung. Es kommt zur Bildung von neuen Morphologien und Strukturen, in diesem Fall zu Nanodrähten und fraktalen Strukturen.

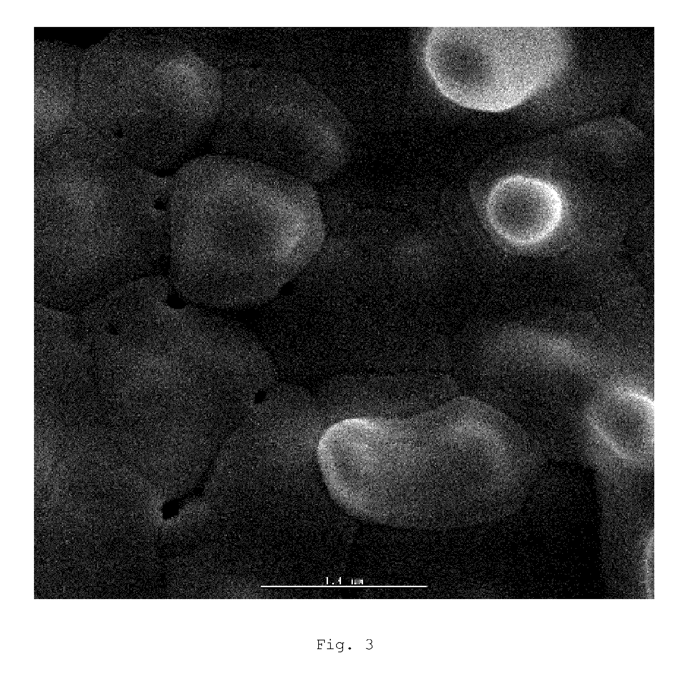

Fig 3 zeigt eine bis zur vollständigen Umwandlung behandelte Al/Al₂O₃-Kompositstruktur. Es sind nur wenige Defekte zu erkennen und die Oberfläche erscheint einheitlich.

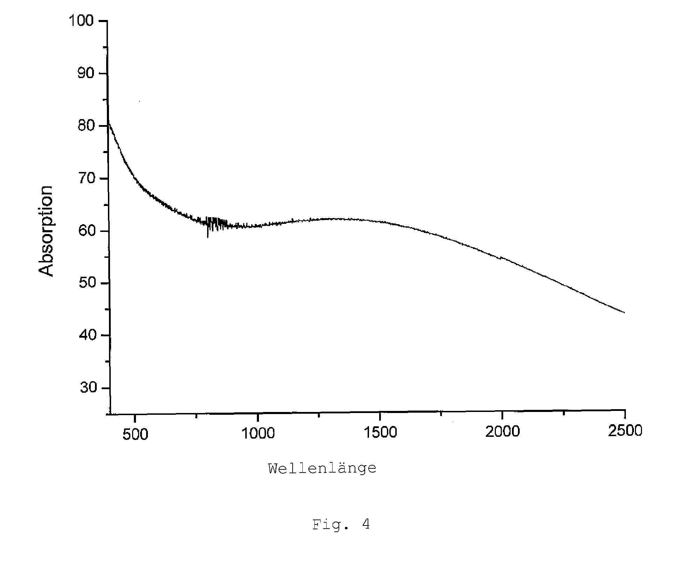

Fig 4 zeigt ein die breite Absorption der Al/Al₂O₃-Kompositstruktur (Dicke: 200-400 nm). Die Absorption in einem breiten Wellenlängenbereich ermöglicht die Verwendung von Lasern in einem breiten Wellenlängenbereich.

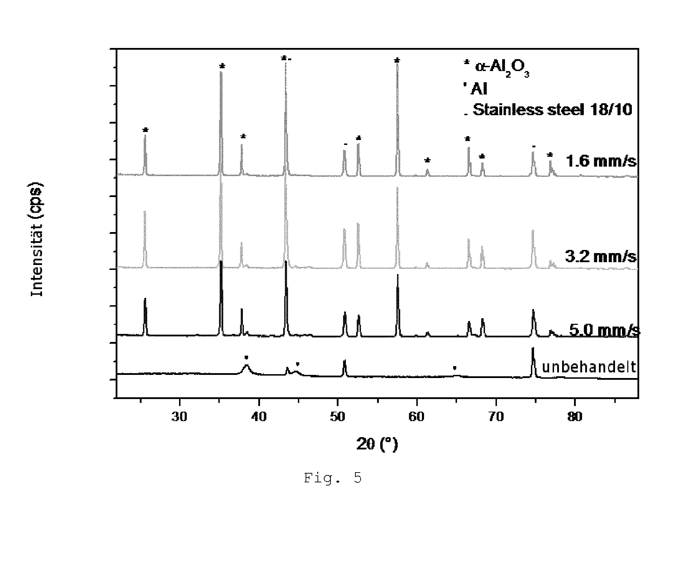

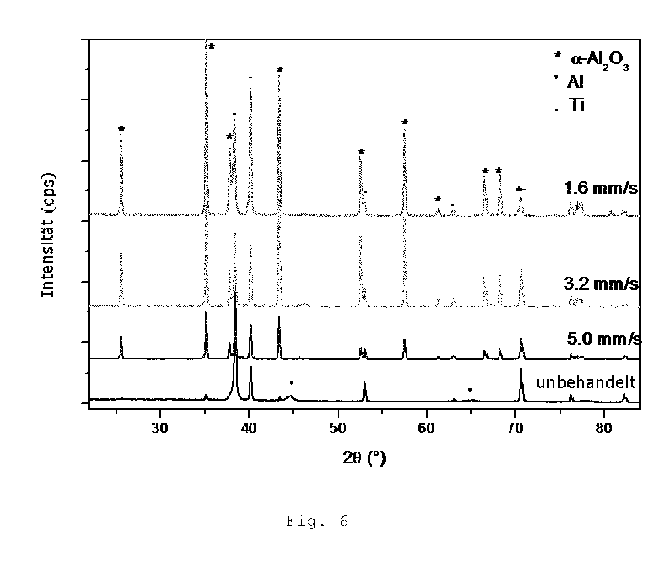

Fig 5 und Fig 6 zeigen eine Röntenbeugungsanalyse von verschiedenen Al/Al₂O₃-Kompositstrukturen, welche unterschiedlich lange behandelt wurden auf zwei verschiedenen Substraten. Es ist deutlich ein Entstehen und die Zunahme der Signale der α-Al₂O₃-Kristallstruktur zu erkennen, während die Signale des metallischen Aluminiums abnehmen. Dies zeigt eine zunehmende Kristallisation und Bildung von α-Al₂O₃.

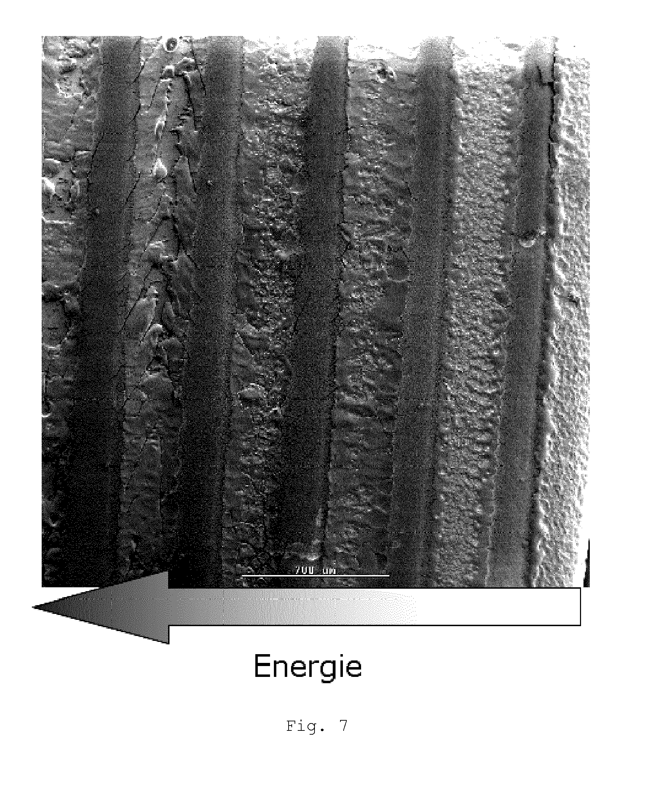

Fig 7 zeigt die selektive Umwandlung in bestimmten Bereich abhängig von der Energie. Auf der gezeigten Al/Al₂O₃-Kompositstruktur wurden streifenförmige Bereiche mit nach links hin zunehmender Behandlungsintensität, welche jeweils durch unbehandelte Streifen getrennt sind, gemäß dem erfindungsgemäßen Verfahren erzeugt. Es ist deutlich die präzise Auflösung und die Genauigkeit zu erkennen, mit welcher das erfindungsgemäße Verfahren die gezielte Herstellung von Strukturen auf Oberflächen ermöglicht.

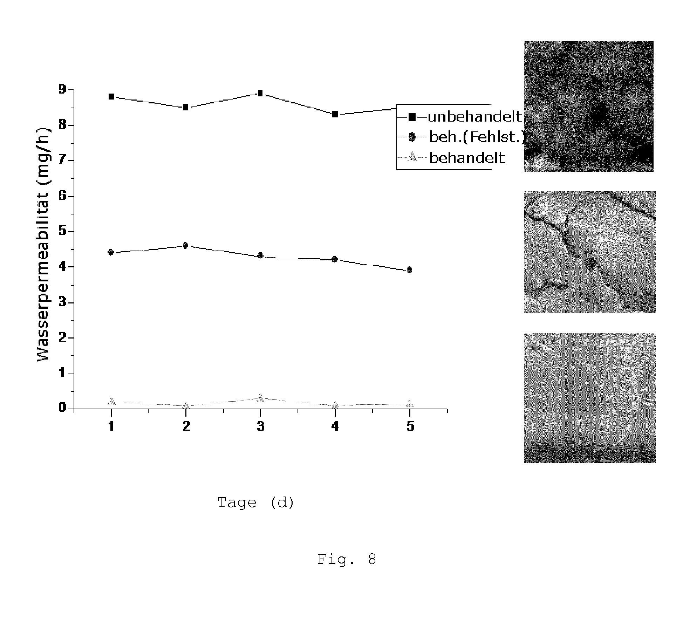

Fig 8 zeigt die Wasserpermeabilität verschieden behandelter Al/Al₂O₃-Kompositstrukturen. Während die unbehandelte Al/Al₂O₃-Kompositstruktur (oben, Quadrate) eine hohe Permeabilität für Wasser zeigt und daher als Korrosionsschutz nicht geeignet ist, zeigt die erfindungsgemäße vollständig umgewandelte Al/Al₂O₃-Kompositstruktur keine Permeabilität (unten, Dreiecke). Eine Al₂O₃-Beschichtung mit Fehlstellen (Mitte, Kreise) weist dagegen eine deutlich höhere Permeabilität auf. Dies zeigt wie wichtig eine genaue Kontrolle der Umwandlungsbedingungen zur Herstellung widerstandsfähiger und sicherer Schutzschichten ist.

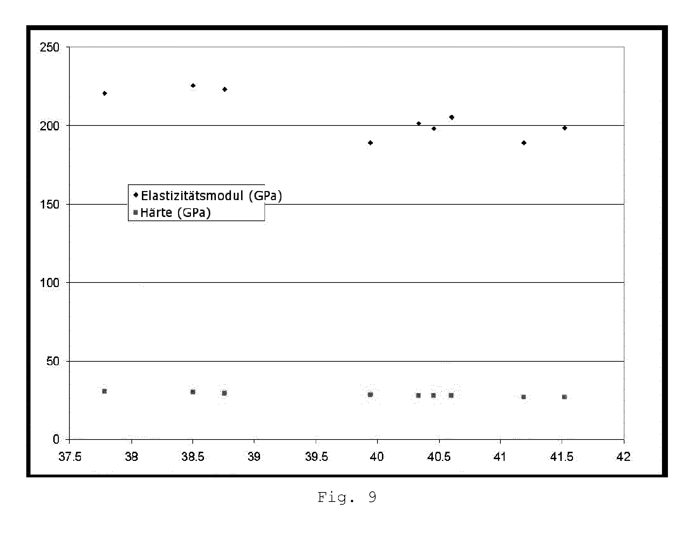

Fig 9 zeigt die Messung der Härte einer vollständig umgewandelten Al/Al₂O₃-Kompositstruktur mit Hilfe von *nano intendation.* Dabei wurde eine Härte von 28 (+/- 2) GPa gemessen.

### Ausführungsbeispiele:

### a) Herstellung der Element/Element-Kompositstruktur

Der Precursor Alumuninium-tert.-butoxiddihydrid (Al(tBu)H₂) wurde in einer CVD-Apparatur unter Argon bei einer Temperatur von 600 °C auf einen metallenen Substrat (Stahl, Kupfer, Nickel oder Platin) oder alternativ auf Glas oder Keramiken abgeschieden. Die Heizung des Ofens erfolgte induktiv, wobei im Falle des Glas ein leitender Probenhalter eingesetzt wurde. Der Druck im Reaktor betrug ungefähr 6.0 x 10⁻² mbar. Die flüchtigen Abbauprodukte des Precursors (darunter Wasserstoff und Isobuten) wurden mit einem angeschlossenen Massenspektrometer detektiert. Für eine Al/Al₂O₃-Kompositstruktur mit einer Schichtdicke von ungefähr 1 µm betrug die Dauer des Zustroms an Precursor ungefähr 10 Minuten. Bei längerer Dauer (30 bis 90 Minuten) konnten höhere Dicken erhalten werden. Die erhaltene Al/Al₂O₃-Kompositstruktur ist wegen ihrer Absorption dunkel bis schwarz gefärbt.

### b) Lokale Erhitzung

Die lokale Erhitzung wurde mit Hilfe eines Lasers durchgeführt. Zum einen wurde ein luftgekühlter CO₂-Laser mit einer Wellenlänge von 10.6 µm eingesetzt, der durch eine bikonvexe ZnSe-Linse mit einer Brennweite von 120 mm fokussiert wurde. Der Belichtungsdurchmesser betrug 10-12 mm und die Umwandlungsbreite des Lasers auf dem Substrat ca. 20-25 µm. Die Intensität des Lasers wurde zwischen 1 W/cm² und 5 W/cm² variiert. Dieser Laser wird von der Al/Al₂O₃-Kompositstruktur und der Aluminiumoxidschicht absorbiert.

Desweiteren wurde ein Argonionenlaser mit Wellenlängen im Bereich des sichtbaren Lichts eingesetzt, der mit Hilfe einer bikonvexen Linse mit der Brennweite von 120 mm fokussiert wurde. Der Belichtungsdurchmesser betrug 10-12 mm und die Umwandlungsbreite des Lasers auf dem Substrat ca. 20-25 µm. Für die Bestrahlung der Al/Al₂O₃-Kompositstruktur wurden die Wellenlängen 514 nm, 488 nm, sowie ein Wellenlängenbereich von 450 nm bis 532 nm *(mixed line)* verwendet. Die Intensität wurde zwischen 0.4 W/cm² und 2 W/cm² variiert. Dieser Laser wird nur von der Al/Al₂O₃-Kompositstruktur und nicht von der bei vollständiger Umwandlung erhaltenen Aluminiumoxidschicht absorbiert.

Bei brüchigen Substraten, insbesondere bei einigen Gläsern und Keramiken, wurde ein gepulster Laser verwendet. Dabei konnten dünne, und sehr dünne Schichten von Al/Al₂O₃-Kompositstruktur Beeinflussung des Substrats behandelt werden. Dazu wurden Laser mit den Wellenlängen 266 nm, 355 nm, 532 nm oder 1064 nm verwendet. Die Intensität wurde gering gehalten und lag bei 200 Joule bei einer Pulslänge von 4-8 ns. Der Belichtungsdurchmesser betrug 10-12 mm und die Umwandlungsbreite des Lasers auf dem Substrat ca. 20-25 µm. Die Behandlung wurde sowohl mit einem einzelnen Puls, wie auch mit einer Wiederholung von Pulsen mit einer Rate von 10 Hz durchgeführt. Dadurch konnte eine geringe Eindringtiefe des Lasers von nur 200-300 nm erreicht werden. Dies erlaubte die Herstellung von sehr dünnen Oxidschichten (<300 nm und sogar <200 nm) mit besonders hohem Korrosionsschutz und mit einer Härte von 28 (+/- 2) GPa.

### Liste der zitierten Literatur:

US 6,521,203
US 5,302,368
US 5,654,035
US 6,713,172
US 5,683,761
US 7,238,420
US 6,048,954
US 6,007,764
WO 2007/102143
DE 10 2006 013 484 A1
DE 19529241
Pradhan et al. "Crystallinity of Al2O3 films deposited by metalorganic chemical vapour deposition", Surface and Coating Technology, 176,(2004),382-384
Triantafyllids et al. "Surface treatment of alumina-based ceramics using combined laser sources", Applied Surface Science, 186,(2002),140-144
Zheng et al. "Effect of core-shell composite particles on the sintering behaviour and properties of nano-Al2O3/polystyrene composite prepared by SLS", Materials Letters,60, (2006), 1219-1223

## Patentansprüche

1. Lichtenergieabsorbierende Beschichtungen für Solarzellen, Lichtschutzbeschichtungen oder Sonnenkollektoren umfassend eine Element/Elementoxid-Kompositstruktur erhalten durch die thermolytische Zersetzung von metallorganischen Verbindungen der Formel El(OR)ₙH₂ worin El Al, Ga, In oder Tl bedeutet und R für einen aliphatischen oder alicyclischen Kohlenwasserstoffrest steht und n den Wert 1 oder 2 hat, auf einer Oberfläche bei einer Temperatur von mehr als 450 °C und bei einem Druck zwischen 10⁻⁴ bis 10⁻¹ mbar unter Bildung einer Element/Elementoxid-Kompositstruktur.

2. Lichtabsorbierende Beschichtung nach Anspruch 1, **dadurch gekennzeichnet, dass** El für Al steht.

3. Lichtabsorbierende Beschichtung nach Anspruch 1 oder 2, **dadurch gekennzeichnet, dass** Aluminium-tert.-butoxy-dihydrid als metallorganische Verbindung verwendet wird.

4. Lichtabsorbierende Beschichtung nach einem der vorhergehenden Ansprüche, **dadurch gekennzeichnet, dass** die thermolytische Zersetzung bei einer Temperatur zwischen 450 °C und 650 °C durchgeführt wird.

5. Solarzellen, Lichtschutzbeschichtungen oder Sonnenkollektoren umfassend eine lichtabsorbierende Beschichtung nach einem der Ansprüche 1 bis 4.

6. Verwendung einer lichtabsorbierenden Beschichtung nach einem der Ansprüche 1 bis 4 für Solarzellen, Lichtschutzbeschichtungen oder Sonnenkollektoren.
